**Europäisches Patentamt**

**European Patent Office**

**Office européen des brevets**

(19)

(11) Publication number: **0 130 103**
A1

(12) # EUROPEAN PATENT APPLICATION

(21) Application number: **84401161.9**

(22) Date of filing: **06.06.84**

(51) Int. Cl.⁴: **H 01 L 27/14**
**H 04 N 3/14, H 01 L 31/04**

(30) Priority: **21.06.83 US 506291**

(43) Date of publication of application:
**02.01.85 Bulletin 85/1**

(84) Designated Contracting States:
**DE FR GB IT NL**

(71) Applicant: **FAIRCHILD CAMERA & INSTRUMENT CORPORATION**
**464 Ellis Street**
**Mountain View California 94042(US)**

(72) Inventor: **Chan, Yum Tom**
**13439 Beaumont Avenue**
**Saratoga California(US)**

(74) Representative: **Chareyron, Lucien et al,**
**Schlumberger Limited Service Brevets c/o Giers, B.P. 121**
**12, place des Etats-Unis**
**F-92124 Montrouge Cedex(FR)**

(54) Charge-coupled device image sensor and method for asynchronous readout.

(57) A CCD image sensor and method for asynchronous read-out without combining charge packets. A plurality of photoelements (PE) is associated with a plurality of sequentially connected CCD storage elements (CCD). Each CCD element is connected to receive and store the electrical charge produced by an associated photoelement as a charge packet. Charge packets are shifted out of the CCD elements by selectively transferring the charge packet from the first in the sequentially connected CCD storage elements during a first time period to empty the first storage element without effecting a transfer from any other CCD storage element and thereafter transferring charge packets only to an empty CCD storage element in the sequence of CCD storage elements, thereby avoiding the combining of charge packets during the transfer. The asynchronous transfer technique is applicable to both CCD linear and area image sensors and permits the use of CCD serial shift registers (20) having CCD storage elements in substantially equal in number to the number of photoelements, avoiding the usual requirement of CCD storage elements numbering twice the number of photoelements.

EP 0 130 103 A1

./...

Fig.3

## CHARGE-COUPLED DEVICE IMAGE SENSOR
## AND METHOD FOR ASYNCHRONOUS READOUT

### BACKGROUND OF THE INVENTION

The present invention relates to solid state image sensors and, more particularly, to a charge-coupled device (CCD) image sensor and method in which the readout of the CCD image sensor is by the asynchronous transfer of charge packets.

CCD image sensors have been available for several years and are used more and more extensively in commercial applications to provide an electrical "image" of either all or part of a scene. A typical CCD linear image sensor comprises a linear sequence of photosensitive elements (photoelements) on a silicon chip while a CCD area image sensor comprises an array of photosensitive elements arranged on a silicon chip in a pattern of horizontal rows and vertical columns. Each photosensitive element produces a "charge packet" of free electrons proportional in number of the amount of light striking it or, more accurately, the incident illumination intensity and the integration period (period of exposure). Each charge packet is selectively stored in an associated CCD storage element of a serial transport shift register and is shifted to an output device for use in reproducing an image of the scene or for analysis of the visual characteristics of the scene.

One specific CCD area image known as the CCD 222, produced by the assignee of the present invention, is organized as a matrix array of 488 horizontal lines or row and 380 vertical columns of charge coupled photoelements (488 x 380 element CCD image sensor). The Fairchild CCD 222 is provided with a vertical transport shift register for each column of photoelements. The vertical transport registers are all clocked synchronously to move the horizontal rows or lines of charge packets, each representing a line of video information, vertically to a horizontal transport shift register. As the horizontal transport register receives each full line of charge packets, it serially shifts the horizontal line to an output device.

The structure of the vertical transport shift registers is such that there is one CCD stage of the vertical transport register associated with each photoelement and each successive CCD stage is directly interconnected to form the vertical transport register. Charge packets may be stored in immediately successive CCD stages to produce an entire 488 x 380 element frame of stored video by using appropriate clock signals. However, the transfer of charge packets from stage to stage in a synchronous fashion i.e. with all charge packet being vertically shifted simultaneously from one stage to the next, results in a consolidation or combining of pairs of charge packets. The vertical resolution of the video output signals is thereby reduced to 244 lines or half the available resolution.

Accordingly, CCD area image sensors structured like the CCD 222, hereinafter referred to as interline charge transfer area image sensors, are normally used as field imaging devices to produce two separate but vertically interlaced fields of video information. The charge packets produced by all odd numbered rows or horizontal lines of photoelements are first stored and synchronously transported vertically to the horizontal transport register to produce a first field. The even numbered horizontal lines of charge packets are then stored and synchronously transported vertically to the horizontal transport register to produce a second field. The two interlaced fields comprise a frame of video information.

By storing and vertically transporting only every other horizontal line when each field is sampled, there is one empty CCD stage between each stage of the vertical transport register containing a charge packet. Thus, as the clock pulses transfer the charges vertically to the horizontal transport register, the combining of pairs of charge packets is avoided and the vertical resolution of the interlaced frame is 488 lines.

Typical CCD linear image sensors are similar in structure to one vertical column of the area image sensor but have two CCD transport shift registers associated with the line of photoelements. One CCD transport register on one side of the photoelements has a CCD storage element for each photoelement, but only every other photoelement is connected to an associated storage element. The other CCD transport register on the other side of the photoelements likewise has a CCD storage element for each photoelement, but only every other photoelement not connected to the first CCD transport register is connected to an associated storage element.

Since each of the two CCD transport shift registers is equal in numerical length to the photoelements and is connected in an alternating pattern thereto, there is a CCD element between each element initially receiving and storing a charge packet so the charge packets produced by the entire line of photoelements can be simultaneously stored and shifted out to an output device. Of course, means must be provided to combine or interlace these two separate series of stored charge packets in order to output a full line of video information in its proper sequence. One typical CCD linear image sensor of the type described above is the CCD 111, a 256 line scan image sensor available from the assignee of the present invention.

There are instances in which it is desirable to use a CCD area image sensor with full frame readout rather than interlaced field readout. Using current techniques with currently available CCD interline charge transfer are image sensors configured like the CCD 222, this is only possible by sacrificing half of the vertical resolution. To obtain the same vertical resolution with full frame readout would require twice as many horizontal lines of photoelements and CCD stages.

Currently available CCD linear image sensors provide for synchronous full line storage readout without sacrificing resolution, but at the added cost and complexity of CCD storage elements numbering at least twice the number of photoelements. The size of the chip is thus necessarily larger than one requiring fewer CCD storage elements, and increased size and complexity is undersirable primarily from a cost standpoint.

## OBJECTS AND BRIEF SUMMARY OF THE INVENTION

It is therefore an object of the present invention to provide a novel CCD image sensor with fewer CCD storage elements than known sensors of equal storage and transfer characteristics.

It is another object of the present invention to provide a novel method and CCD area image sensor readout system which provides frame readout of CCD interline charge transfer area image sensors without sacrificing any of the available vertical resolution.

It is yet another object of the present invention to provide a novel method and apparatus for asynchronously reading a CCD interline charge transfer device in order to avoid combining pairs of charge packets in immediately adjacent CCD stages.

It is yet another object of the present invention to provide a novel method and apparatus for asynchronously transferring charge packets stored in successive stages of a CCD interline charge transfer device in order to avoid combining pairs of charge packets as they are transferred from stage to stage, particularly to avoid sacrificing vertical resolution in a CCD interline charge transfer area image sensor operating in a frame storage and readout mode.

In accordance with the invention, these and other objects and advantages are accomplished through the asynchronous transfer of stored charge packets from one CCD stage to another starting with the transfer of the charge packet stored in the first CCD stage and progressing in an asynchronous manner until there is an empty stage between each stage containing a charge packet.

More specifically, pairs of switches controlling the vertical transfer of charge packets are sequentially enabled or turned on so that the charge packet stored in the first CCD stage of each vertical transport register is transferred out of the first stage to a CCD storage element intermediate the first storage stage and the horizontal transport register by a first phase of a two-phase clock signal. Next, the charge packet stored in the second CCD storage stage is transferred, by a second phase of the two phase clock signal, from the second stage to the first stage, while the charge packet in the intermediate stage is simultaneously transferred to the horizontal transport register. This process continues much like a "ripple effect", with the charge packet in each succeeding stage of the CCD register being shifted for the first time after the charge packet in the immediately preceeding stage has been shifted, and thereafter in each clock shift period. Upon the occurrence of clock shift period (n/2), each CCD storage stage containing a charge packet is separated from all others by an empty CCD stage, all transfer control switches are on, and the transfer proceeds in the ordinary fashion.

In the preferred embodiment of the invention, pairs of vertical transfer control switches controlling the vertical transfer of charge packets are selectively enabled by the output signals from a vertical scan register which sequentially enables the first switch pair, the second switch pair and so on until all switches are enabled. The clock pulses fed to these switches are ineffective to cause a charge transfer unless enabled. The vertical scan register is preferably a binary shift register which initially contains all binary ZERO's and is loaded with binary ONE's, starting with the first stage controlling the first pair of CCD transfer switches, until all stages of the binary shift register contain ONE's and all vertical transfer switches are enabled.

## BRIEF DESCRIPTION OF THE DRAWINGS

The foregoing objects and advantages will become more apparent to one skilled in the art to which the invention pertains from the following detailed description when read in conjunction with the appended drawings in which:

Figure 1 is a functional block diagram of a known CCD linear image sensor arranged for full line charge transfer using two CCD transport shift registers;

Figure 2 is a functional block diagram illustrating a known CCD area image sensor arranged for interline charge transfer in the vertical direction;

Figure 3 is a functional block diagram illustrating a preferred embodiment of a CCD area image sensor according to the present invention showing the readout or transfer control section in detail;

Figure 4 is a signal diagram indicating the timing of various clock signals which cause the asynchronous transfer of charge packets in the area image sensor of Figure 3; and

Figure 5 is a diagram illustrating the asynchronous transfer of charge packets along a portion of a CCD vertical transport register in accordance with the principles of the invention.

## DETAILED DESCRIPTION

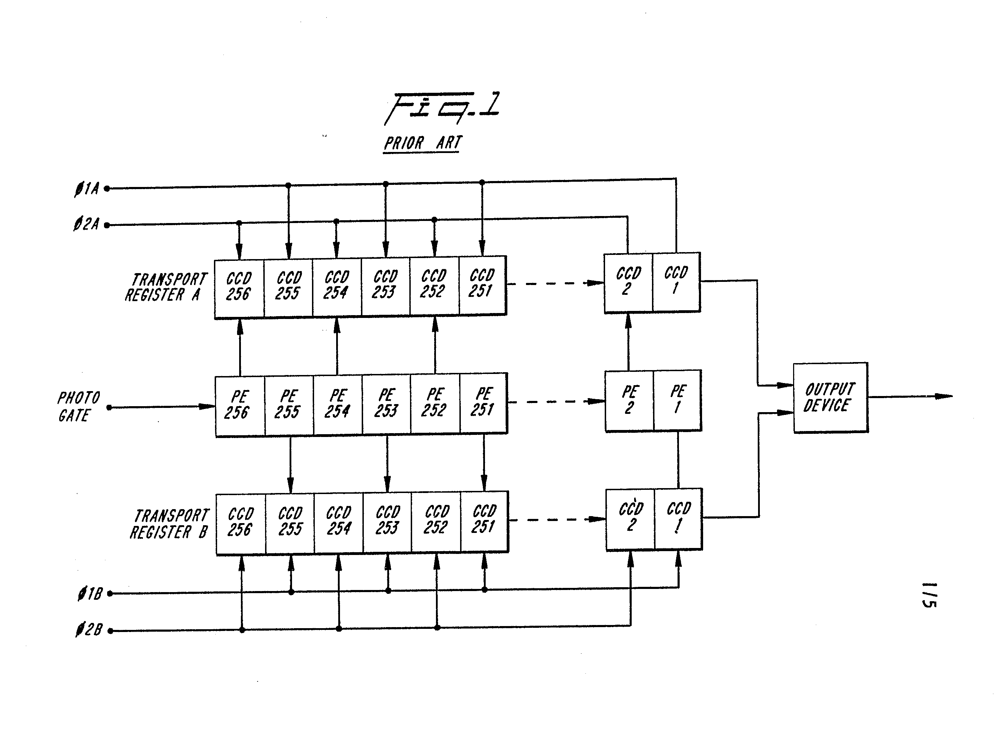

Figure 1 illustrates a known CCD linear image sensor with 256 photoelements. The photoelements PE1 – PE256 are arranged in-line and are typically side by side in a sequential fashion separated by a defused channel stop and covered by a silicon photogate. Image photons pass through the transparent photogate and are absorbed in the single crystal silicon creating hole-electron pairs. The free electrons produced by the photons from the image are accumulated by each photoelement with the amount of charge being a linear function of the incident illumination intensity and the integration of period. The electrical charge accumulated in each photoelement will vary in an analog manner from a thermally generated background level at zero illumination to a maximum at saturation under bright illumination.

Transport registers A and B are provided on either side of the line of photoelements. Each transport register comprises serially connected CCD elements equal in number to the number of photoelements PE. Thus, transport register A is made up of 256 CCD elements, CCD 1 - CCD 256. Transport register B similarly includes 256 elements CCD 1 - CCD 256. Transfer gates (not shown) provide gating between the photoelements and the respective transport registers A and B in order to control the transfer of charge packets from the photoelements to the transport registers. In this connection, every other photoelement, e.g. the even numbered photoelements, are connected to supply charge packets to the corresponding CCD elements of the transport register A. The remaining alternating photoelements, e.g. the odd numbered elements, are connected to supply their charge packets to corresponding CCD elements of the transport register B. Thus, every other CCD element in each of the transport registers will be empty upon initial transfer of charge packets from the photoelements and during transport of the stored charge packets along the length of the transport registers.

Appropriately phased clock signals $\emptyset$ la and $\emptyset$ 2a are supplied to the transport register A in order to shift the stored charge packets to a suitable output device. Similarly, appropriately phased clock signals $\emptyset$ lb and $\emptyset$ 2b are supplied to the CCD elements of the transport register B in order to serially shift the stored charge packets from this register to the output device.

The illustrated CCD linear image sensor of Figure 1 is fabricated on a semiconductor chip in a conventional manner and may include other circuitry not illustrated. For example, the chip may include amplifying circuitry as well as circuitry to insure proper recombining of the two transport register output signals in order to properly reproduce the original serial sequence of the line of video information produced by the photoelements. It should be understood, therefore, that the functional block diagram of Figure 1 is for illustrative purposes and further details may be obtained through available literature on such commercial devices.

In operation, the photogate signal controls the amount of time during which charge is allowed to accumulate in the photoelements PE, i.e. the integration period. At the end of the integration period, the transfer gates between the photoelements and the CCD transport registers (not shown) are clocked to transfer the accumulated charge packets in the photoelements to the associated stages or elements of the CCD transport registers. Alternate charge packets are transferred to the transport shift registers as illustrated.

The transport register clock signals shift the charge packets stored in the transport registers synchronously to the output device. During the first clock period, for example, the charge packets stored in transport register A are all shifted simultaneously to the adjacent, connected CCD element which was previously empty. The charge packets in transport register B are similarly shifted. Thus, an empty CCD element is always maintained between any two CCD elements containing stored charge packets. The consolidation of charge packets is therefore avoided.

Eventually all 256 charge packets are transported to the output device where there are interlaced to provide a full line of video information. It will be appreciated that approximately one-half of the charge packets are transported by the tranport register A and the other half are transported by the transport register B. The synchronous approach to the transfer of charge packets to the output device results in a requirement for at least twice as many CCD storage elements as they are photoelements.

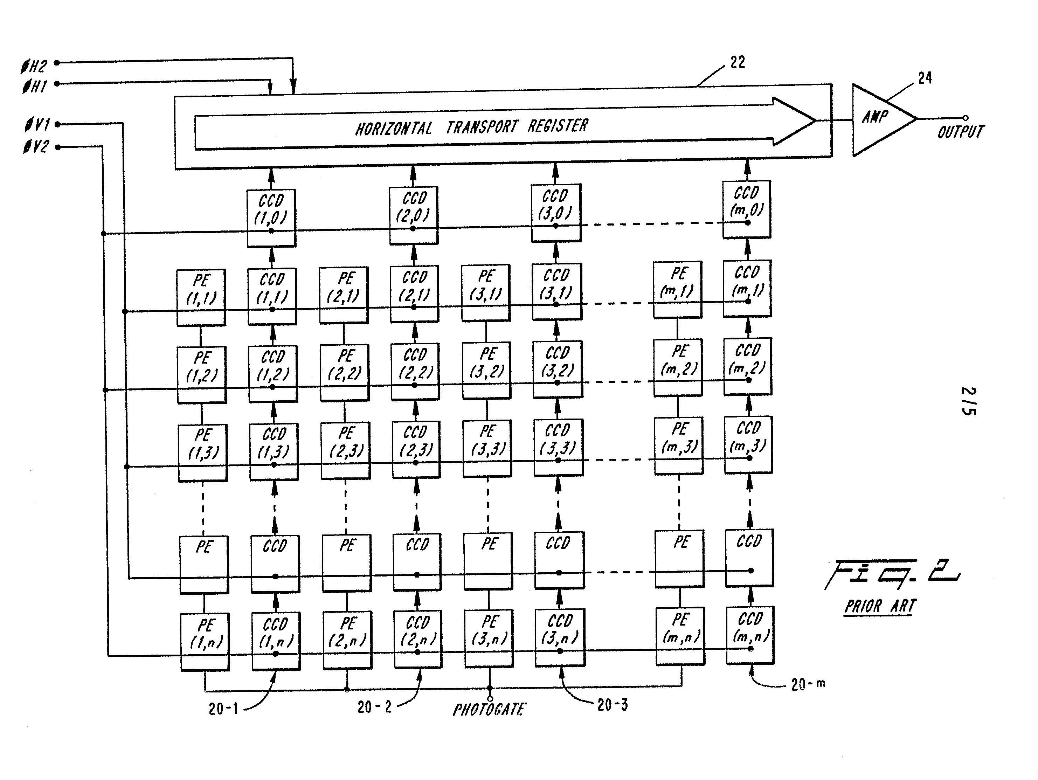

Figure 2 illustrates a known CCD area image sensor comprising an m by n matrix of photoelements and associated CCD storage elements. The photoelements PE are arranged in n horizontal rows and m vertical columns. Each photoelement in Figure 2 is identified by its column and row number in that order. Thus, the photoelement in the first column and first row is PE (1,1) while the last photoelement in the first column, the element in row n, is PE (1,n). Similarly, the photoelement in the second column and third row is PE (2,3), etc. A transparent photogate (not shown) overlying each column of photoelements is controlled by a photogate clock to control the integration period of the photoelements.

Each column of photoelements 1 through m has an associated vertical transport shift register 20-1 through 20-m, each comprising serially connected CCD storage elements. The CCD storage elements are identified in Figure 2 using the same row and column numbering system used in connection with the photoelements PE.

Each photoelement is coupled to an associated CCD storage element in the adjacent vertical transport register. In the illustrated CCD area image sensor, an extra row of CCD elements, CCD (1,0) - CCD (m,0) is provided for one stage buffer storage between each vertical transport shift register and a horizontal transport shift register 22. Two-phase horizontal clock drive signals Ø H1 and Ø H2 shift the charge packets through the horizontal transport shift register 22 to an output circuit 24. Two-phase clock drive signals Ø V1 and Ø V2 control the readout (vertical shifting) of charge packets from the vertical transport regtster 20.

In operation, the image of a scene is focused on the active region of the CCD area image sensor. The photogate clock enables the photogates for a predetermined period of time and the photoelements accumulate charge as a linear function of the incident illumination and the time period of enablement (the integration period).

At the end of the integration period when the photogate voltage is lowered; the Ø V1 clock signal goes HIGH and the charges accumulated by the photoelements in the odd-numbered rows are transferred to the associated CCD storage elements to initiate an odd-field readout. At the time, only the odd numbered horizontal rows of CCD storage elements contain charge packets produced by the photoelements. These charge packets are shifted vertically to the horizontal transport shift register 22 in a synchronous manner, i.e., all charge packets are simultaneously shifted vertically one row into an adjacent, empty CCD storage element upon the occurrence of each vertical shift clock. Eventually every row of charge packets, each representing a line of video, is shifted into the horizontal transport register 22 which shifts the rows horizontally to the output 24. In this manner, every other line of video is read during the first, odd-field readout.

The even-field readout is the same as the odd-field readout except the even-numbered rows of photoelements are read to the exclusion of the odd-numbered rows. The photogate signal again controls the accumulation of charge packets for a predetermined integration period and, at the end of that period, the $\emptyset$ V2 clock signal goes HIGH, transferring the charge packets accumulated by the even rows of photoelements into the associated CCD storage elements. Again, since only every other row of photoelement signals is transferred into the vertical transport registers, alternate CCD storage elements are empty and synchronous vertical transfer can be used for even-field readout.

The resultant video signals is a two-field signal having lines that can be interlaced to produce a full frame. There are applications, however, in which full frame readout rather than successive field readout is desirable.

The area image sensor of Figure 2 can be used for such full frame readout application by modifying the clock drive signals $\emptyset$ V1 and $\emptyset$ V2 so that they are both HIGH during the LOW level photogate pulse and all photoelements charge packets are transferred to the vertical transport register. This creates a condition in which each successive CCD storage stage of the vertical transport registers contains a stored charge packet. When the charge packets are transferred vertically in a synchronous manner, the charge packets pair up as half of them move from the LOW clock phase CCD element upward into the
adjacent HIGH clock phase element and combine with the charge
packet already stored there.  No more pairing occurs after this
initial clock period since every other CCD stage is then empty.
However, one-half of the vertical resolution of the sensor is
lost because of the initial pairing or consolidation of charge
packets.

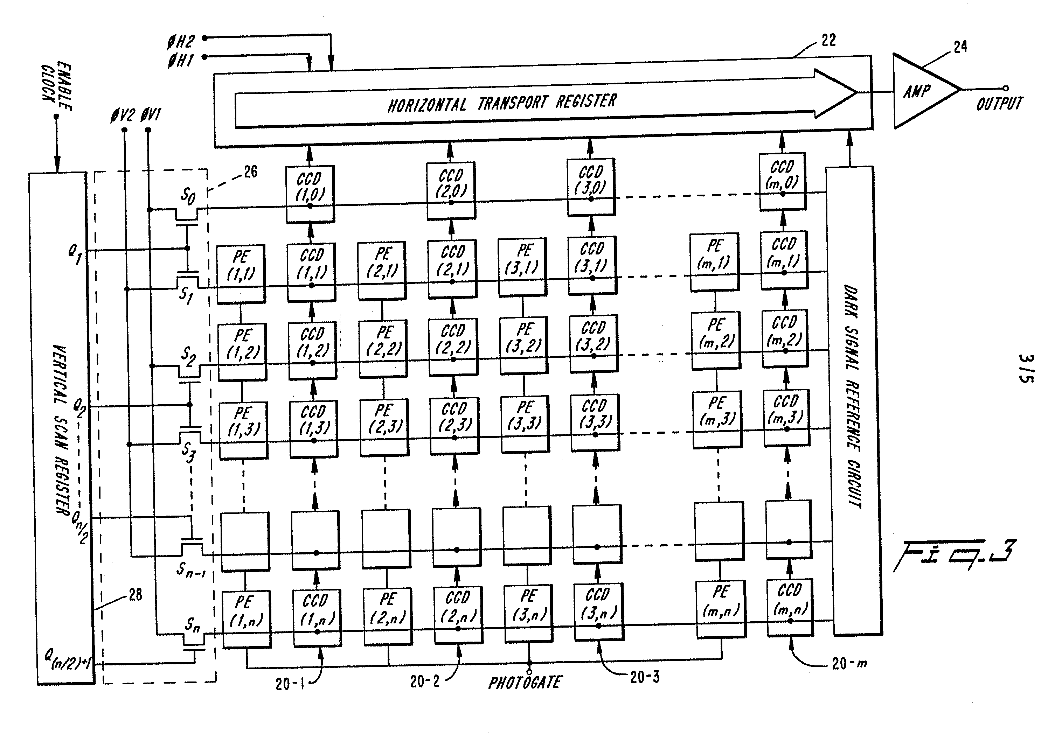

The present invention avoids the need for additional
CCD storage elements to prevent the pairing of charge packets,
and the loss of resolution if additional CCD stages are not
provided, by an asynchronous clocking arrangement.  In Figure 3,
one embodiment of a CCD area image sensor in accordance with the
present invention is illustrated.  It will be appreciated by one
skilled in the art that each vertical column of photoelements and
associated CCD storage elements is, in essence, a linear image
sensor.  Accordingly, the principles discussed hereinafter in
connection with Figure 3 are applicable to CCD linear image
sensors and such sensors made in accordance with the present
invention will not·be separately described.

In Figure 3, like numerical designations are used to
indicate elements previously described in connection with Figure
2.  As can be seen, the CCD area image sensor of Figure 3 is
identical to that of Figure 2 with respect to the array of
photoelements and CCD's.  The horizontal rows and vertical
columns of photoelements and associated CCD storage elements are
numerically designated (1,1) through (m,n) as in Figure 2.

The primary differences between the prior art area
image sensor of Figure 2 and that of Figure 3 reside in the clock
circuitry method used to transfer charge packets from the photoelements to their associated CCD storage elements and to read (vertically shift) the vertical transport shift registers. Also, as will be seen hereinafter, a dark current reference circuit may be provided to maximize accuracy.

The clock circuitry which shifts the charge packets vertically along the vertical transport shift registers 20-1 through 20-m is arranged for asynchronous shifting to permit full frame readout with substantially equal number of photoelements and CCD storage elements in the sensor array. Switches S0 through Sn, generally indicated at 26, control the vertical transfer of charge packets stored in the corresponding stages of the vertical transport registers 20. The switches S0 through Sn are controlled in pairs by the output signals from a vertical scan register 28 which is preferably a binary shift register with $(n/2)+1$ stages.

In particular, the signal from the switch S0 controls the potential applied to the horizontal row of CCD storage elements CCD (1,0) - CCD (m,0). Similarly, the signal from switch S1 controls the potential on row 1 of CCD elements designated CCD (1,1) - CCD (m,1), and so forth through switch Sn which controls the potential on row n. The switches are paired by connecting the gate electrodes of switches So and S1, S2 and S3, etc. Assuming an even number of horizontal rows as with the Fairchild CCD 222 which has 488 rows, the gate electrode of the last switch Sn is not connected to any other gate electrode.

The output signals Q1 through $Q(n/2)+1$ of the vertical scan register control the gating of the respective pairs of coupled gate electrodes of switches S0-Sn in response to an enable clock signal. Thus, for example, Signal Q1 is applied to

the common gate electrode of switches S0 and S1, the signal Q2 is applied to the common gate electrode of switches S2 and S3, and so forth. The two-phase vertical clock signals Ø V1 and Ø V2 is connected to one side of each of the switches S0-Sn such that one phase (ØV1) is connected to switch S0 and all the even-numbered switches S2, S4, S6, ...Sn and the other phase (ØV2) is connected to all of the odd-numbered switches S1, S3, S5, ... Sn-1.

In operation, the photoelements are exposed to an image of a scene and they accumulate charge during the integration period. The vertical scan register 28 is set (either from a previous cycle or by a SET signal which sets all stages to a binary ONE), and all of the Q1-Q(n/2)+1 output signals from the register 28 are HIGH. Thus all the switches S0-Sn are gated on or enabled.

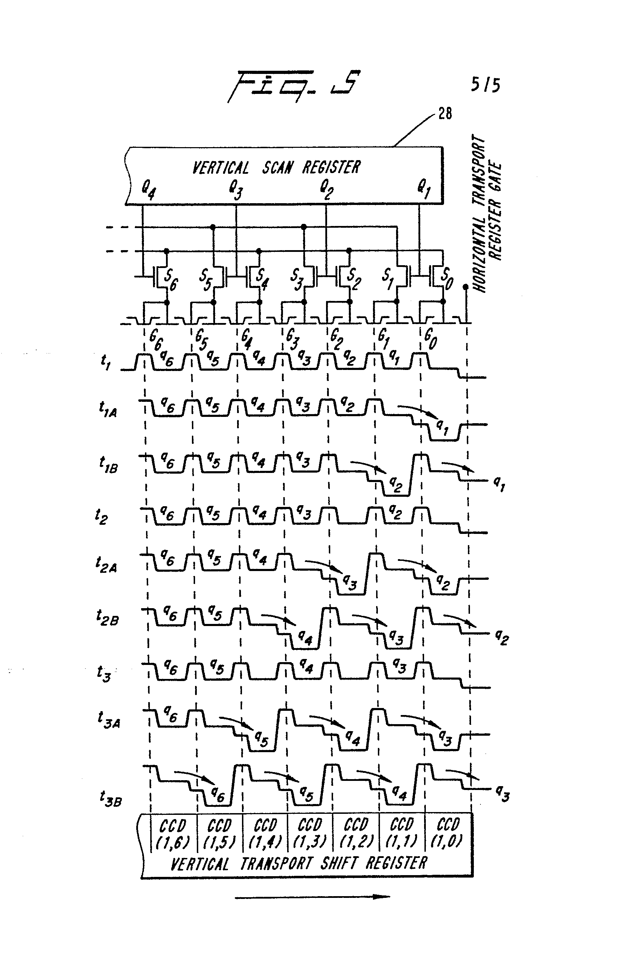

Both phases of the vertical clock signal ØV1 and ØV2 go HIGH after the photogate signal goes LOW, and all the accumulated charge packets in the photoelements are transferred to their corresponding CCD storage elements. Thus, an entire frame of charge packets is stored in the vertical transport registers and there are no intermediate empty CCD storage elements in the vertical transport shift registers. This initial stage of charge storage is shown for part of one vertical transport register in Figure 5 wherein the transfer gates G0 through G6 for the first six CCD storage elements of a vertical transport shift register are shown together with the charge packets q1 through q6 stored in these first six storage elements.

The vertical scan register 28 is reset so that all its output signals are low. A first enable clock signals is applied to the vertical scan register at time t1 and the first stage Q1

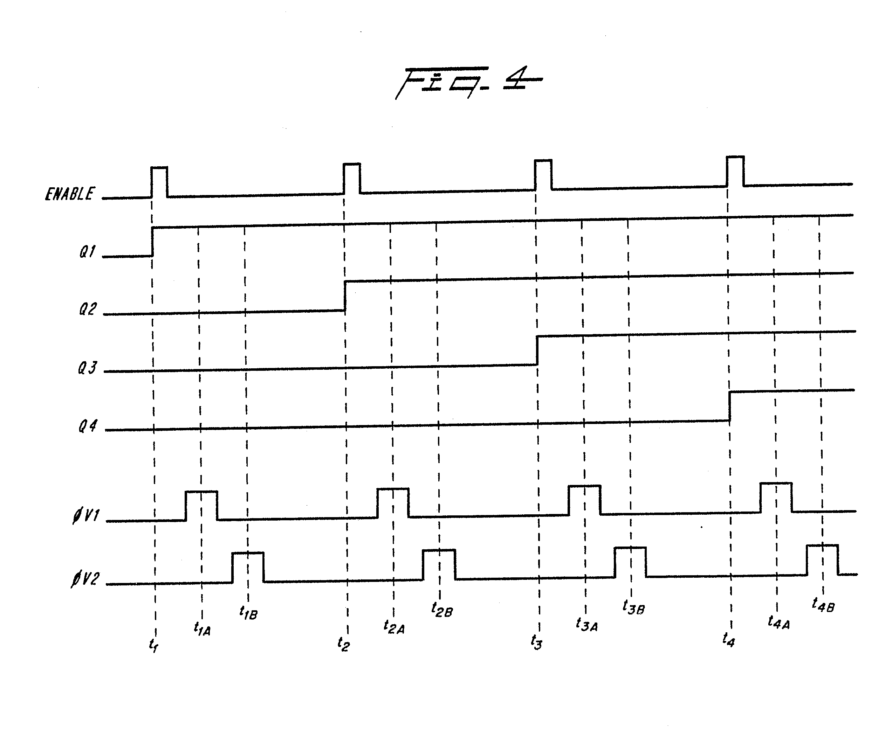

of this register is set or, in essence, loaded with a binary ONE as indicated in Figure 4. As was previously mentioned the vertical scan register is preferably a shift register and the enable clock signal may be a series of ONE's which sequentially load each stage of the shift register so that, after $(n/2)+1$ enable clock pulses, all the stages and thus all the output signals Q1 through $Q(n/2)+1$ are HIGH. Thus, at time t1 and thereafter until the entire frame has been shifted out of the vertical transport shift registers, the Q1 signal is HIGH and the switches So and S1 are gated on so that the vertical clock signals ØV1 and ØV2 are connected to horizontal rows 0 and 1 of the vertical transport registers.

At time t1A the vertical transfer clock ØV1 is HIGH while the clock ØV2 is LOW, causing the charge packet q1 in elements CCD (1,1) through CCD (m,1) (the first horizontal row) which have gates G1 having low gate potentials to be transferred to the elements CCD (1,0) through CCD (m,0) with gates GO having high potentials (see Figure 5). At time t1B, the vertical clock ØV1 is LOW and the vertical clock ØV2 is HIGH. Charge packets q2 in elements CCD (1,2) through m,2) (the second horizontal row) are transferred to the empty CCD storage elements in horizontal row 1 and the charge packets in storage elements CCD (1,0) through CCD (m,0) are transferred to the horizontal transport register. No other charge packets are transferred at times t1A and t1B because all other switches are off.

At the end of the first set of the two-phase clocks ØV1, ØV2, the charge packet q1 in the first stage CCD(1,1) of the CCD vertical transport register has been shifted two stages, one stage for each clock pulse, and is thus transferred through CCD (1,0) to the horizontal transport shift register. The charge packet q2 has been shifted one stage on the occurrence of the second phase vertical clock ØV2 after the charge packet ql is shifted out of CDD (1,1). In other words, a first stored charge packet is shifted by a first clock pulse to empty a first shift register element or stage. The next clock pulse shifts a second charge packet into the stage vacated by the first charge packet and simultaneously shifts the first charge packet another stage. Thus, at the end of the first two clock pulses, the first charge packets has been shifted one stage so that there is an empty shift register stage between it and the second charge packet, and both charge packets have been shifted together so that there is also an empty shift register stage between the second and third stored charge packets (see Figure 5, waveform t2).

At time t2, the second enable clock pulse has been shifted into the vertical scan register 28 and the output signal Q2 is HIGH. Thus, switches S2 and S3 are enabled along with switches S0 and S1 which previously were enabled. At time t2A, the clock ØV1 is HIGH and ØV2 is LOW. Charge packets q2 and q3 each are shifted one stage, leaving empty stages CCD (1,1) and CCD (1,3). The next clock ØV2 at time t2b shifts charge packets q2, q3 and q4.

This process of enabling the clocking of successive pairs of shift registers stages continues, starting with the first pair nearest the output stage CCD (1,0) as discussed above, until all the switches S0-Sn are enabled and every shift register stage can be clocked. At this time, there is an empty CCD stage between each one containing a charge packete and the shifting proceeds synchronously in the sense that all charge packets are simultaneously shifted in response to the clock signals. No combining of charge packets occurs because of the asynchronous shifting during the time when immediately successive stages contained charge packets.

The principles, preferred embodiments and modes of operation of the present invention have been described in the foregoing specification. The invention which is intended to be protected herein, however, is not to be construed as limited to the particular forms disclosed, since these are to be regarded as illustrative rather than restrictive. Moreover, variations and changes may be made by those skilled in the art without departing from the spirit of the present invention.

<u>CLAIMS</u>

1. A CCD image sensor comprising:
a plurality of photoelements [PE(1,1), PE(1,n)] each producing a packet of electrical charges related in magnitude to the intensity of light incident thereon;
a plurality of sequentially connected CCD storage elements [CCD(1,1), CCD(1,n)] each connected to receive and store the electrical charge produced by an associated photoelement as a charge packet, characterized by comprising:
means (26, 28) for selectively transferring the charge packet from the first [CCD(1,1)] in the sequentially connected CCD storage elements during a first time period to empty the first storage element [CCD(1,1)] without effecting a transfer from any other CCD storage element and thereafter transferring charge packets only to an empty CCD storage element in the sequence of CCD storage elements [CCD(1,1), CCD (1,n)], thereby avoiding the combining of charge packets during the transfer.

2. The CCD image sensor of claim 1 characterized in that said photoelements [PE(1,1), PE(1,n)] are arranged linearly to form a CCD linear image sensor.

3. The CCD image sensor of claim 1 characterized in that said photoelements are arranged in a plurality of horizontal rows [PE(1,1), PE(m,1)] and vertical columns [PE(1,1), PE(1,n)], and including a plurality of sequentially connected CCD storage elements associated with each column of photoelements and forming a vertical transport shift register for the associated column, thereby forming a CCD area image sensor.

4.  The CCD image sensor of any one of claims 1 to 3 characterized by further comprising an additional CCD storage element [CCD(1,0)] connected to the first of said sequentially connected CCD storage elements to receive the charge packet transferred from said first CCD storage element.

5.  The CCD image sensor of any one of claims 1 to 4 characterized in that said selective transferring means comprises transfer control means (26) for controlling the transfer of charge packets from each CCD storage element, and means (28) for successively enabling each transfer control means during successive transfer periods.

6.  The CCD image sensor of claim 5 characterized in that said successive enabling means (28) comprises a multi-stage binary shift register connected to said transfer control means (26), and means for successively loading a predetermined binary signal level into each stage of the shift register during each successive transfer period.

7.  A method for shifting a plurality of charge packets stored in a CCD serial shift register (20-1) to the output of the serial shift register, the charge packets being initially stored in a plurality of sequential stages [CCD(1,1), CCD(1,n)] of the shift register without intermediate empty stages, the method characterized by comprising the steps of:

starting with the first charge packet which is in the shift register stage [CCD(1,1)] nearest the output of the shift register, shifting the charge packet in each of the plurality of serial shift register stages [CCD(1,1), CCD(1,n)] from its initial storage stage into an immediately successive storage stage only after the charge packet in the immediately successive storage stage has been shifted; and,

after a charge packet has been shifted from its initial storage stage into the immediately successive storage stage, shifting said previously shifted charge packet each time any other charge packet is shifted until each stored charge packet is shifted to the output of the serial shift register.

8. The method of claim 7 characterized in that the charge packets are shifted from their initial storage stages to the immediately successive stages of the shift registers asynchronously by successively enabling the clocking of the shift register stages such that a charge packet can only be shifted to the immediately successive storage stage after the shifting of immediately successive stage has been enabled.

9. The method of claim 8 characterized in that the clocking of the shift register stages is accomplished by a two-phase clock signal (ØV1, ØV2) and the enabling step comprises enabling the clocking of successive pairs of shift register stages.

10. The method of claim 9 characterized in that the step of shifting the charge packets asynchronously comprises:

(a) enabling the clocking of a pair of first and second shift register stages [CCD(1,2), CCD(1,3)] the second stage being further from the output than the first stage;

(b) applying the two-phase clock signal (ØV1, ØV2) to the enabled pair of shift register stages to first shift the charge packet from the second stage into the first stage of the enabled pair of stages and then shift the charge packet from the first stage of an adjacent pair of stages into the second stage of said enabled pair after said second stage has been emptied and while shifting the charge packet out of the first stage of the enabled pair;

(c) maintaining the pair of first and second shift register stages enabled; and

(d) repeating steps (a) through (c) for each adjacent pair of shift register stages until all shift register are enabled to be clocked.

FIG. 1

PRIOR ART

Fig. 2
PRIOR ART

ENABLE CLOCK

ØH2  ØH1

ØV2  ØV1

22 — HORIZONTAL TRANSPORT REGISTER

24 — AMP — OUTPUT

VERTICAL SCAN REGISTER

26

$S_0$ — CCD (1,0)  CCD (2,0)  CCD (3,0)  CCD (m,0)

$Q_1$ — $S_1$ — PE (1,1)  CCD (1,1)  PE (2,1)  CCD (2,1)  PE (3,1)  CCD (3,1)  PE (m,1)  CCD (m,1)

$S_2$ — PE (1,2)  CCD (1,2)  PE (2,2)  CCD (2,2)  PE (3,2)  CCD (3,2)  PE (m,2)  CCD (m,2)

$Q_2$ — $S_3$ — PE (1,3)  CCD (1,3)  PE (2,3)  CCD (2,3)  PE (3,3)  CCD (3,3)  PE (m,3)  CCD (m,3)

$Q_{n/2}$

$S_{n-1}$

28

$S_n$ — PE (1,n)  CCD (1,n)  PE (2,n)  CCD (2,n)  PE (3,n)  CCD (3,n)  PE (m,n)  CCD (m,n)

$Q_{(n/2)+1}$

DARK SIGNAL REFERENCE CIRCUIT

20-1  20-2  PHOTOGATE  20-3  20-m

FIG-3

3/5

0130103

FIG. 4

ENABLE

Q1

Q2

Q3

Q4

∅V1

∅V2

$t_1$   $t_{1A}$   $t_{1B}$   $t_2$   $t_{2A}$   $t_{2B}$   $t_3$   $t_{3A}$   $t_{3B}$   $t_4$   $t_{4A}$   $t_{4B}$

4/5

0130103

Fig. 5    5/5

# EUROPEAN SEARCH REPORT

EP 84401161.9

## DOCUMENTS CONSIDERED TO BE RELEVANT

| Category | Citation of document with indication. where appropriate, of relevant passages | Relevant to claim | CLASSIFICATION OF THE APPLICATION (Int. Cl. ³) |
|---|---|---|---|
| A | ELEKTRONIKSCHAU 3/83, Wien "Halbleiter-Videokamera" pages 54, 56 <br> * Fig. 2-6; page 54, last paragraph - page 56, right column, first paragraph * <br> -- | 1,3,4, 5,6,9 | H 01 L 27/14 <br> H 04 N  3/14 <br> H 01 L 31/04 |
| A | US - A - 3 683 193 (WEIMER) <br> * Fig. 1,2,8; abstract * <br> -- | 1,2,3, 4,5,9 | |
| A | EP - A2 - 0 039 177 (HITACHI) <br> * Fig. 2-4; abstract * <br> -- | 1,3,5, 6,9 | |
| A | DE - A1 - 2 542 156 (SIEMENS) <br> * Claims 1,2,5,6 * <br> ---- | 1,2,4, 5,6,9 | **TECHNICAL FIELDS SEARCHED (Int. Cl. ³)** <br><br> H 01 L <br> H 04 N |

The present search report has been drawn up for all claims

| Place of search | Date of completion of the search | Examiner |
|---|---|---|
| VIENNA | 31-08-1984 | HEINICH |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82